(19) Europäisches Patentamt
European Patent Office
Office européen des brevets

(11) **EP 2 848 951 A1**

(12) **EUROPEAN PATENT APPLICATION**

(43) Date of publication:
**18.03.2015 Bulletin 2015/12**

(51) Int Cl.:
***G01R 31/333*** (2006.01)   ***H01H 33/16*** (2006.01)

(21) Application number: **13184845.9**

(22) Date of filing: **17.09.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventors:
• **Heiermeier, Helmut**
**79793 Wutöschingen (DE)**

• **Kurinko, Carl**
**North Huntingdon, 15642 (US)**
• **Andrae, Gunnar**
**5400 Baden (CH)**

(74) Representative: **ABB Patent Attorneys**
**c/o ABB Schweiz AG**
**Intellectual Property CH-IP**
**Brown Boveri Strasse 6**
**5400 Baden (CH)**

(54) **Test system and method for high voltage circuit breakers**

(57)     A method for testing a high voltage circuit breaker comprises providing a high voltage circuit breaker (15) having at least two interrupting chambers (20, 25) in series, providing a varistor (40) having a nonlinear current-voltage characteristic, electrically connecting the varistor (40) in parallel to at least one of the interrupting chambers (20, 25) in order to provide a voltage-dependent bridging for that at least one interrupting chamber (20), applying a high test current through the complete high voltage circuit breaker (15), wherein the greatest part of the test current flows through the interrupting chambers (20, 25), and only an insignificantly small part through the varistor (40), applying a synthetic test high voltage across the complete high voltage circuit breaker (15), which leads to a decline of the varistor resistance. Further, a respective test system (10) is provided.

Fig. 3

**Description**

TECHNICAL FIELD

The present disclosure generally relates to testing methods for electrical devices. More particularly, it relates to synthetic short circuit and switching test methods for high voltage circuit breakers and to a respective testing system.

BACKGROUND OF THE INVENTION

Testing of high voltage circuit breakers for ultra high voltage (UHV) applications which have two or more interrupting chambers in series is often not possible as a full pole test. This is due to limitations of known test plants, in particular with respect to the highest test voltage achievable. It is assumed that in a test taking into account all possible operating scenarios of the circuit breaker to be tested, a test must include a case in which practically the entire test voltage is applied across the interrupting chambers. Thus, international standards, such as IEC 62271-100/203/101 and ANSI/IEEE C37.04/06/09, require full pole tests of such circuit breakers, since a certain interaction between the individual interrupting chambers of the breakers can be assumed. For life tank circuit breakers, a common way to overcome this problem is to apply only a fraction $u_{test}$ of the synthetic test voltage $u_{testfullpole}$, which is required for a full pole test, across one or more interrupting chamber(s),

$$u_{test} / u_{testfullpole} = (\text{Number of tested chambers} / \text{Total number of chambers})$$

$$* \text{voltage distribution factor}$$

while the test current flows through the complete circuit breaker. Testing in such a way will result in the correct mechanical stress for the test object, as well as in correct dielectric stress for the tested interrupting chamber with applied TRV (transient recovery voltage).

Thereby, the transient recovery voltage (TRV) is a voltage which appears under real life operating conditions across the terminals of a pole of a circuit breaker. This voltage may be described as a transient part (several 100 $\mu$s) followed by the power frequency voltage part (several 100 ms), both of which are applied as a synthetic test voltage $u_{test}$ from at least one external voltage source.

During an interruption process of the circuit breaker, the developing arc rapidly loses conductivity, as the current approaches zero. Within a few microseconds after current zero, current stops flowing in the circuit breaker. The power system response to the current interruptions is what generates the TRV. The difference in the power system response voltage from the source side to the load side of the circuit breaker is the TRV. The breaking operation is successful, if the circuit breaker is able to withstand the TRV and the power frequency recovery voltage. TRV is then related to the power system response to an interruption of current in a circuit very close to a power frequency current zero. The nature of the TRV is dependent on the circuit being interrupted, whether primarily resistive, capacitive or inductive, or some combination of these. Additionally, distributed and lumped circuit elements will produce different TRV wave shapes. In principle, the response of the load side and source side of the circuit breaker can be analyzed separately, and the results subtracted point by point on a time line. The driving voltage will be the instantaneous power frequency voltage across the circuit elements at the instant of current interruption. If there is no damping, the highest peak circuit response would be two times the peak of the driving voltage. The proportion of the system voltage across each piece of the switched circuit will be determined by the impedance of each piece at the power frequency.

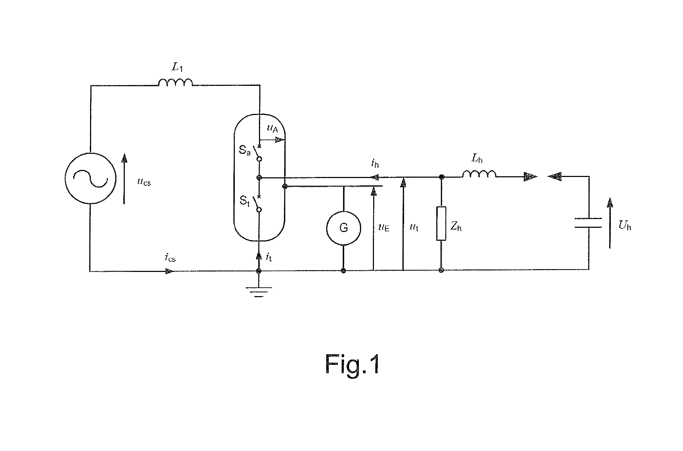

For dead tank breakers (DTB) as well as gas insulated switchgear (GIS) breakers, such a testing method is basically also possible, but requires the use of an additional bushing. This bushing allows an electrical contact (a middle contact) of a section between the individual interrupting chambers or switching units in the circuit breaker with a testing circuit outside the breaker. However, the use of such an additional bushing has several disadvantages: It requires a significant design change for the enclosure, such as an additional flange for the bushing, a high current connection, and causes a significantly differing field distribution, etc.. The TRV can only be applied in between the interrupting chamber. The possible exhaust stress is correct only for the intermediate position. A conventional test system with such a middle contact, typically realized via the described bushing, is shown in Fig. 1. Therein, the following symbols are assigned, and voltages appear:

$S_a$ = unit(s) of the circuit breaker used as auxiliary circuit breaker

$S_t$ = unit(s) of the circuit breaker used as test circuit breaker

G = source supply of $u_E$ applied to the enclosure

$u_{CS}$ = voltage of the current circuit

$i_{CS}$ = current of the current circuit

$i_h$ = injected current

it = current through $S_t$

$L_1$ = inductance of the current circuit

$L_h$ = inductance of the voltage circuit

$Z_h$ = equivalent surge impedance of the voltage circuit

$u_E$ voltage applied to the insulated enclosure

$u_t$ voltage applied to the contact gap of the unit(s) under test (resulting voltage between the terminal not earthed of the unit under test and the enclosure; a linear distribution of the voltage between the units is assumed)

$u_A$ resulting voltage between one terminal and the enclosure

$u_C$ peak of the TRV

$U_h$ = applied voltage

In view of the above, there is a need for a testing method and system for circuit breakers which avoids the disadvantages of known solutions.

SUMMARY OF THE INVENTION

The problems mentioned above are at least partly solved by a method according to claim 1 and a testing system according to claim 10.

In a first aspect, a method for testing a high voltage circuit breaker is provided. It includes providing a high voltage circuit breaker having at least two interrupting chambers in series, providing a varistor having a nonlinear current-voltage characteristic, electrically connecting the varistor in parallel to at least one of the interrupting chambers in order to provide a voltage-dependent bridging for that at least one interrupting chamber, and applying a test current through the complete high voltage circuit breaker, wherein the greatest part of the test current flows through the interrupting chambers, and only an insignificantly small part through the varistor, and applying a synthetic test high voltage across the complete high voltage circuit breaker, which leads to a decline of the varistor resistance.

In a further aspect, a test system including a high voltage circuit breaker is provided, wherein the high voltage circuit breaker has at least two interrupting chambers in series, and a varistor having a nonlinear current-voltage characteristic, being electrically connected in parallel to at least one of the interrupting chambers, in order to provide a voltage-dependent bridging for that at least one interrupting chamber.

With the described method and system, no significant design changes of testing hardware are required. The varistor, preferably comprising ZnO, can for example be used instead of a typically applied grading capacitor. The varistor can be used at any interrupting chamber. In addition, it is possible to energize the enclosure in order to achieve the correct voltage difference between active parts and the enclosure.

Further aspects, advantages and features of the present invention are apparent from the dependent claims, claim combinations, the description and the accompanying drawings.

BRIEF DESCRIPTION OF THE DRAWINGS

A full and enabling disclosure, including the best mode thereof, to one of ordinary skill in the art is set forth more particularly in the remainder of the specification, including reference to the accompanying figures, wherein:

Fig. 1 schematically shows a known testing system for ultra high voltage circuit breakers having a middle contact;

Fig. 2 schematically shows a testing system according to embodiments with currents and voltages applied according to embodiments of a method;

Fig. 3 schematically shows the testing system of Fig. 2, with currents and voltages applied according to embodiments of a method with energized enclosure;

Fig. 4 schematically shows a further view of the testing system of Fig. 2, with currents and voltages applied according to embodiments of a method; with energized enclosure;

Fig. 5 schematically shows a diagram of a method according to embodiments;

Fig. 6 shows a diagram of voltages over time in a test circuit according to embodiments.

DETAILED DESCRIPTION OF THE INVENTION

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

The systems and methods described herein are not limited to the specific embodiments described, but rather components of the systems and/or steps of the methods may be utilized independently and separately from other components and/or steps described herein. Thus, the exemplary embodiment can be implemented and be used in connection with many other applications.

Although specific features of various embodiments of the invention may be shown in some drawings and not in others, this is for convenience only. In accordance with the principles of the invention, any feature of a drawing may be referenced and/or claimed in combination with any feature of any other drawing.

According to embodiments of the disclosure, in a testing system for a circuit breaker, one or more interrupting chambers of the circuit breaker to be tested are bridged by a varistor. In embodiments, the varistor comprises ZnO. This varistor, which may herein also be called arrestor, is adapted such that it is nonconductive when a current, in particular the test current, from a current source is applied, wherein the current source typically has a significantly lower voltage in comparison to the test voltage, for example from about 20 kV to about 50 kV. Moreover, due to the very low ohmic resistance of the closed circuit breaker during the application of the test current, for example a test current of 10 kA to 100 kA, the voltage of the current source drops nearly entirely in the current source. Consequently, the voltage drop over the individual interrupting chambers and the varistor parallel to one of those is very low in comparison to the external testing voltage. The current flows in series through all interrupting chambers of the circuit breaker to be tested. As a result of a successful switching operation, a TRV appears across the test object. Due to the applied TRV, the ZnO varistor, which bridges at least one interrupting chamber, becomes conductive. Consequently, the applied TRV voltage, reduced by the varistor voltage, appears across the non-bridged interrupting chambers of the circuit breaker. The described testing method and system have the following advantages: No significant design changes of the hardware are needed, except the minor step of adding the ZnO varistor, which may for example replace a grading capacitor which is typically part of the tested circuit breakers. The varistor can be used at any of the interrupting chambers of the circuit breaker to be tested. In embodiments, also more than one of the interrupting chambers may be equipped with a varistor connected in parallel. In addition, it is possible in embodiments to energise the enclosure in order to achieve the correct voltage between active parts and enclosure.

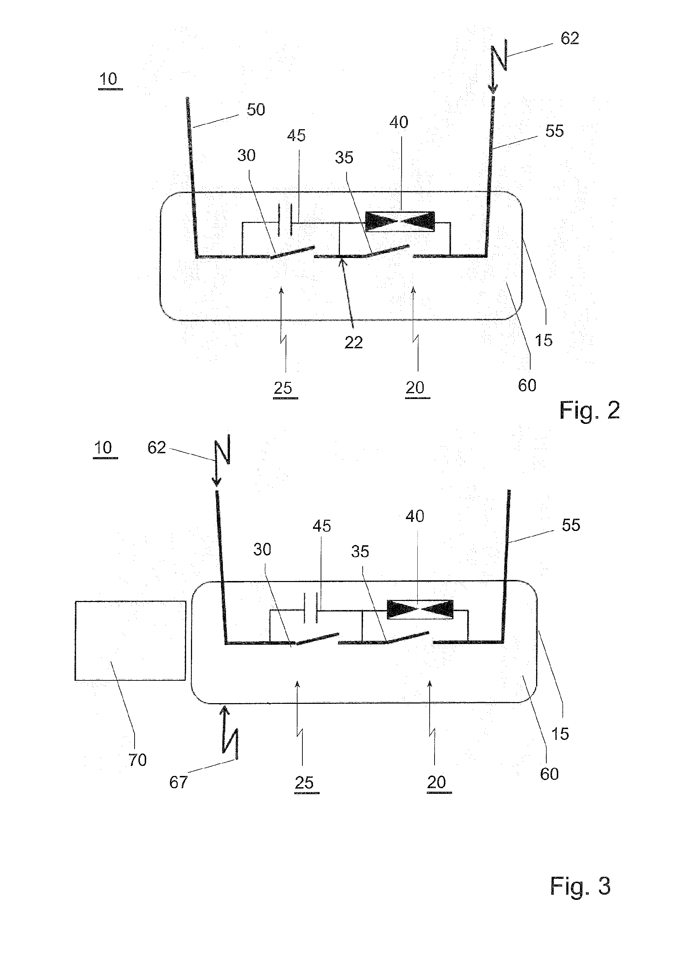

Fig. 2 shows a test system 10 according to embodiments. It comprises a high voltage circuit breaker 1 to be tested. Typically, the circuit breaker 1 includes at least two interrupting chambers 20, 25 in series. A varistor 40 having a nonlinear current-voltage characteristic is electrically connected in parallel to at least one of the interrupting chambers 20, 25 of the circuit breaker 1. The varistor 40 provides a voltage-dependent bridging for the interrupting chamber 20, 25 to which it is connected in parallel.

The varistor 40 is adapted so that it is isolating when a current from an external current source is applied through the circuit breaker 15 via the terminals 50, 55. In this manner, the test current flows through both interrupting chambers 20, 25, or more than two interrupting chambers if applied, and only an insignificant fraction of the test current flows through the varistor. For example, this fractional test current can be in the order of magnitude of a few milliamperes, wherein the main test current through the interrupting chambers 20, 25 of the circuit breaker may for example be from 1000 A to 100.000 A. During application of the test current, the varistor is isolating, and thus only an insignificantly small part of the test current flows through the varistor connected in parallel to one of the interrupting chambers 20, 25. However, when, immediately after the high test current is interrupted by the circuit breaker, the transient recovery voltage TRV is applied across the entire circuit breaker 15, it leads to a complete decline of the resistance of the varistor 40.

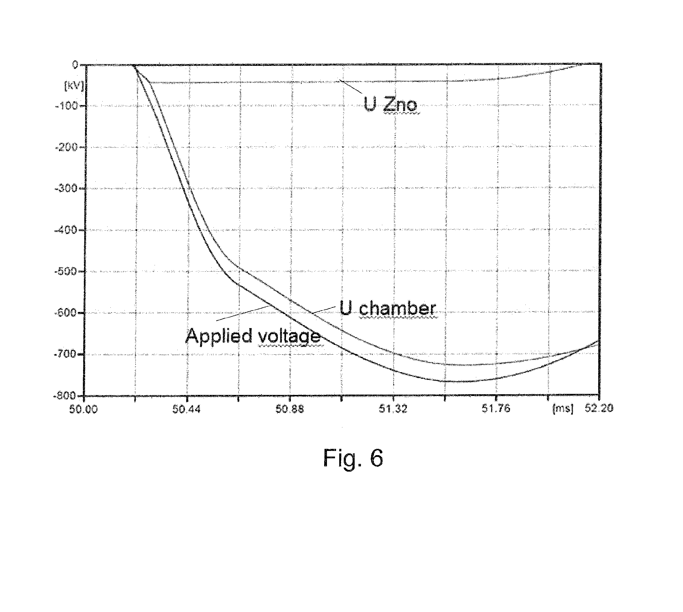

As the varistor 40 is adapted to become conductive when the transient recovery voltage (TRV) is applied, it thus bridges the at least one interrupting chamber to which it is connected in parallel. When the synthetic test high voltage is applied to the entire circuit breaker 15 in the test system 10, the applied synthetic test high voltage reduced by the varistor voltage appears across the non-bridged interrupting chamber(s). In Fig. 6, a graph of these voltages is shown over time. The 'applied voltage' is the synthetic test high voltage applied to the entire circuit breaker 15. $U_{chamber}$ is the voltage drop over the interrupting chamber 20, 25, i.e. the interrupting chamber to be tested which is not bridged by the varistor 40. $U_{ZnO}$ ist the voltage drop over the varistor 40, which bridges one of the interrupting chambers 20, 25. Thus, as can easily be seen, the applied external synthetic test high voltage drops almost entirely as $U_{chamber}$ at the non-brided one of the interrupting chambers 20, 25. In embodiments, the varistor 40 in the test system 10 is adapted to be exchangeable between the at least two interrupting chambers 20, 25. Hence, the full external synthetic test high voltage can be used to test each of the interrupting chambers 20, 25 of the circuit breaker 15 by simply changing the position and contacting of the varistor 40 inside the circuit breaker 15. The external current source for the test current and the external voltage source for the synthetic test high voltage (not shown) are connected to the terminals 50, 55 of the circuit breaker during the test. A further voltage source is, in some embodiments described in the following, connected to the enclosure 60.

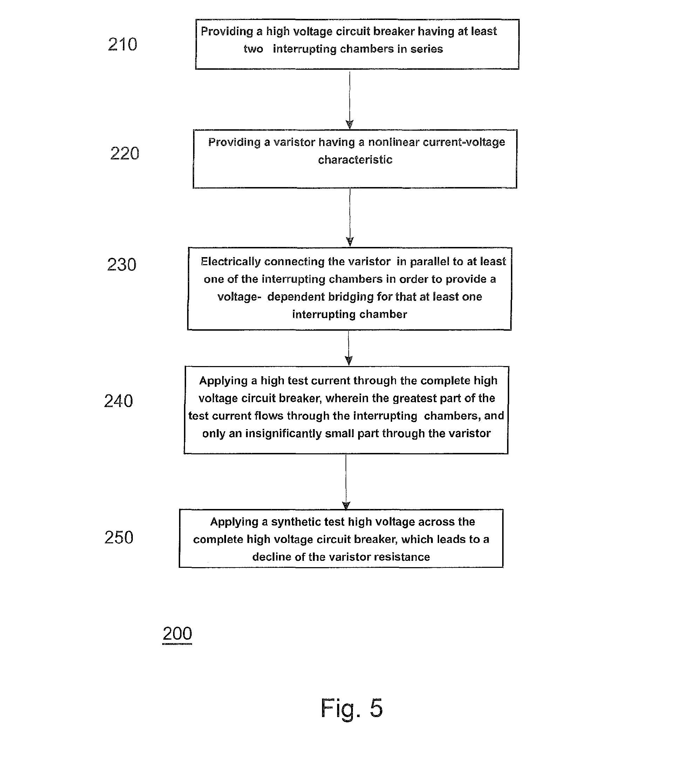

According to embodiments schematically shown in Fig. 5, a method 200 for testing a high voltage circuit breaker comprises providing (in a block 210) a high voltage circuit breaker 15 having at least two interrupting chambers 20, 25 in series. A varistor 40 having a nonlinear current-voltage characteristic is provided in a block 220, then electrically connected in parallel to at least one of the interrupting chambers 20, 25, in order to provide a voltage-dependent bridging for that at least one interrupting chamber, in a block 240. For the test, a test current is applied through the complete high voltage circuit breaker 15. Thereby, the greatest part of the test current flows through the interrupting chambers 20, 25, and only an insignificantly small part of the test current flows through the varistor 40, in the block 240. For example, this fractional test current can be in the order of magnitude of a few milliamperes, wherein the main test current through the interrupting chambers 20, 25 of the circuit breaker from the external current source may be for example from 1000 A to 100.000 A. During application of the test current, the varistor 40 is isolating, and thus only an insignificantly small part of the test current flows through the varistor 40 connected in parallel to one of the interrupting chambers 20, 25. When, immediately after the high test current is interrupted by the circuit breaker, the transient recovery voltage is applied as a first part of the synthetic test high voltage across the entire circuit breaker 15, it leads to a complete decline of the resistance of the varistor 40. Subsequently, a synthetic test high voltage is applied across the entire circuit breaker, as soon as the test current has reached zero after interruption respectively switching. When the synthetic test high voltage is applied to the entire circuit breaker 15 in the test system 10, the applied synthetic test high voltage reduced by the varistor voltage appears across the non-bridged interrupting chamber(s), leading to voltages as shown in Fig. 6 described before.

A typical magnitude of the synthetic test high voltage is in the range of 500 kV to 900 kV. As the varistor 40 is already conductive when the synthetic test voltage is applied, it bridges the at least one interrupting chamber 20, 25 to which it is connected in parallel. The applied synthetic test voltage reduced by the varistor voltage drop $U_{ZnO}$ appears across the non-bridged interrupting chamber(s) as $U_{chamber.}$ The synthetic test high voltage is typically about half of the actual operating voltage (0.5 p.u.) of the tested high voltage circuit breaker. Thus, with half of the actual operating voltage for which the circuit breaker shall be tested, a full-pole-test is possible by using the disclosed method and embodiments thereof.

Typically, in the testing method according to embodiments, the varistor 40 comprises ZnO, and may also comprise other suitable materials having a non-linear voltage-resistivity behavior. It may for example be applied by replacing a grading capacitor 45 of the respective interrupting chamber 20, 25 of the circuit breaker.

In embodiments, various testing modes can be applied in order to simulate various test cases. This includes the application of a high voltage to the enclosure 60 of the circuit breaker, in order to obtain a correct voltage stress between enclosure 60 and active parts of the circuit breaker 15. In Fig. 2, it is shown that a synthetic test high voltage 62 is applied to terminal 55. It has a voltage of 0.5 p.u. of the nominal operating voltage of the circuit breaker 15 plus the typical voltage drop at the varistor 40, such that the voltage drop over the non-bridged interrupting chamber 25 is half of the nominal operating voltage of the circuit breaker 15. This method leads to a correct test voltage across the interrupting chamber 25. Also, the voltage difference between the intermediate contact 22, or intermediate position, and the enclosure 60 is correct.

In Fig. 3, the same synthetic testing voltage 62 (0.5 p.u. of the nominal operating voltage of the circuit breaker 15 plus the voltage drop at the varistor 40) is applied to the other terminal 50. Additionally a second voltage 67 of 0.5 p.u. is applied to the enclosure 60. This leads to the correct voltage between terminal 50 and the enclosure 60.

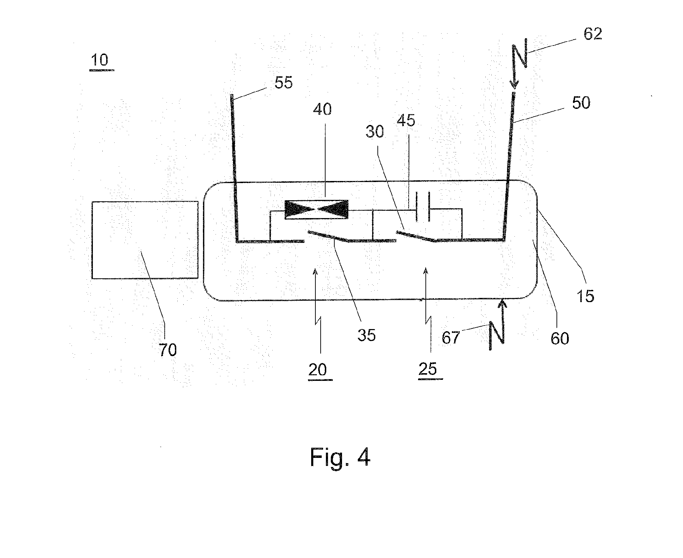

In Fig. 4, the synthetic testing voltage 62 (0.5 p.u. of the nominal operating voltage of the circuit breaker plus the voltage drop at the varistor 40) is applied to the terminal 50 such as in Fig. 3, however in a different arrangement of the circuit breaker drive 70 with respect to the enclosure 60.

Embodiments described herein allow to conduct tests of circuit breakers which fulfill the requirements of full pole tests, but with reduced voltage requirements as presently required in laboratories. The test methods can be performed with minimal structural changes to the tested circuit breakers, and thus with significantly less effort than required in known methods.

This written description uses examples to disclose the invention, including the best mode, and also to enable any person skilled in the art to practice the invention, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

**Claims**

1. A method (200) for testing a high voltage circuit breaker (15), comprising:

- providing a high voltage circuit breaker (15) having at least two interrupting chambers (20, 25) in series (210),
- providing a varistor (40) having a nonlinear current-voltage characteristic (220),
- electrically connecting the varistor (40) in parallel to at least one of the interrupting chambers (20, 25) in order to provide a voltage-dependent bridging for that at least one interrupting chamber (230) ,
- applying (240) a test current through the complete high voltage circuit breaker (15), wherein the greatest part of the test current flows through the interrupting chambers (20, 25), and only an insignificantly small part through the varistor (40),
- applying a synthetic test high voltage across the complete high voltage circuit breaker (15), which leads to a decline of the varistor (40) resistance (250).

2. The method of claim 1, wherein the varistor (40) is adapted such that it is isolating when the test current from a high current source is applied, so that the test current flows through all interrupting chambers (20, 25), and that only an insignificant fraction of the test current flows through the varistor (40).

3. The method of any one of the preceding claims, wherein the varistor (40) is adapted such that it becomes conductive when a transient recovery voltage (TRV) is applied, and thus bridges the at least one interrupting chamber (20, 25) to which it is connected in parallel, so that the applied synthetic test high voltage reduced by the varistor (40) voltage appears across the non-bridged interrupting chamber(s) (20, 25).

4. The method of any one of the preceding claims, wherein the varistor (40) comprises ZnO.

5. The method of any one of the preceding claims, wherein the varistor (40) is applied by replacing a grading capacitor (45) of the high voltage circuit breaker (15).

6. The method of any one of the preceding claims, wherein an enclosure (60) of the high voltage circuit breaker (15) is connected to a voltage in order to achieve a correct voltage stress between active parts of the high voltage circuit breaker (15) and the enclosure (60).

7. The method of any one of the preceding claims, wherein the varistor (40) is applied to a different interrupting chamber (20, 25) after the testing is completed, and wherein the method is repeated.

8. The method of any one of the preceding claims, wherein the varistor (40) has a resistance of at least some MOhm during application of the test current.

9. The method of any one of the preceding claims, wherein the varistor (40) is fully conductive during application of the synthetic test high voltage.

10. A test system (10), in particular a test system (10) for implementing the method of any one of the preceding claims, the test system (10) comprising:

- a high voltage circuit breaker (15) having at least two interrupting chambers (20, 25) in series,
- a varistor (40) having a nonlinear current-voltage characteristic, being electrically connected in parallel to at least one of the interrupting chambers (20, 25), in order to provide a voltage-dependent bridging for that at least one interrupting chamber (20, 25).

11. The test system (10) according to claim 10, being adapted such that the varistor (40) is isolating when a test current from a current source is applied, so that the test current flows through all interrupting chambers (20, 25), and that only an insignificant fraction of the test current flows through the varistor (40).

12. The test system (10) according to any one of the claims 10 to 11, which test system (10) is adapted such that when a test current is applied through the complete high voltage circuit breaker (15), the greatest part of the test current flows through the interrupting chambers (20, 25) in series, and only an insignificantly small part of the test current flows through the varistor (40), and such that when a transient recovery voltage (TRV) is applied across the complete high voltage circuit breaker (15), it leads to a decline of the varistor (40) resistance.

13. The test system (10) according to any one of the claims 10 to 12, wherein the varistor (40) is adapted such that it becomes conductive when the transient recovery voltage (TRV) is applied and thus bridges the at least one interrupting chamber (20, 25) to which it is connected in parallel, so that the applied transient recovery voltage reduced by the varistor (40) voltage appears across the non-bridged interrupting chamber(s) (20, 25).

14. The test system (10) according to any one of the claims 10 to 13, wherein the varistor (40) is adapted to be exchangeable between the at least two interrupting chambers (20, 25) of the high voltage circuit breaker (15).

Fig.1

10

50

30    45    35    40    62

55

15

22

25    20    60

Fig. 2

10    62

30    45    35    40

55

15

70    67    25    20    60

Fig. 3

Fig. 4

210 | Providing a high voltage circuit breaker having at least two interrupting chambers in series

220 | Providing a varistor having a nonlinear current-voltage characteristic

230 | Electrically connecting the varistor in parallel to at least one of the interrupting chambers in order to provide a voltage- dependent bridging for that at least one interrupting chamber

240 | Applying a high test current through the complete high voltage circuit breaker, wherein the greatest part of the test current flows through the interrupting chambers, and only an insignificantly small part through the varistor

250 | Applying a synthetic test high voltage across the complete high voltage circuit breaker, which leads to a decline of the varistor resistance

200

Fig. 5

Fig. 6

Europäisches
Patentamt

European
Patent Office

Office européen
des brevets

# EUROPEAN SEARCH REPORT

Application Number

EP 13 18 4845

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SENDA T ET AL: "Development of HVDC Circuit Breaker Based on Hybrid Interruption Scheme", IEEE TRANSACTIONS ON POWER APPARATUS AND SYSTEMS, IEEE INC. NEW YORK, US, vol. PAS-100, no. 3, 1 March 1984 (1984-03-01), pages 545-552, XP011170510, ISSN: 0018-9510 * paragraph [Synthetic_Test] - paragraph [Reverse_Current_Interruption]; figures 5,1,2,11,12 * * paragraph [Concept_of_Hybrid_IU] - paragraph [Measurement_of_Shared_Voltage] * * page 550 * * abstract * | 1-14 | INV. G01R31/333 H01H33/16 |
| A | DE 34 44 317 A1 (BBC BROWN BOVERI & CIE AG) 15 May 1986 (1986-05-15) * page 4, line 27 - page 5, line 8; figure 1 * * page 6, line 24 - page 8, line 2 * | 1-14 | TECHNICAL FIELDS SEARCHED (IPC) G01R H01H |
| A | US 2011/080684 A1 (ULANOVSKY EDUARD [IL] ET AL) 7 April 2011 (2011-04-07) * paragraph [0029] - paragraph [0044]; figure 4 * | 1-14 | |
| A | US 5 262 605 A (PHAM VAN DOAN [FR] ET AL) 16 November 1993 (1993-11-16) * abstract * * column 1, line 8 - column 2, line 5 * | 1-14 | |

-/--

The present search report has been drawn up for all claims

| Place of search | Date of completion of the search | Examiner |
|---|---|---|
| Munich | 24 February 2014 | Maric, Viktor |

EPO FORM 1503 03.82 (P04C01)

**EP 2 848 951 A1**

Europäisches
Patentamt

European
Patent Office

Office européen
des brevets

# EUROPEAN SEARCH REPORT

Application Number

EP 13 18 4845

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHRISTIAN M FRANCK: "HVDC Circuit Breakers: A Review Identifying Future Research Needs", IEEE TRANSACTIONS ON POWER DELIVERY, IEEE SERVICE CENTER, NEW YORK, NY, US, vol. 26, no. 2, 1 April 2011 (2011-04-01), pages 998-1007, XP011351244, ISSN: 0885-8977, DOI: 10.1109/TPWRD.2010.2095889 * page 4, paragraph A - page 5, paragraph B; figures 2,3 * ----- | 1-14 | |
| X | BRUMSHAGEN H ET AL: "New Developments in Design and Testing of HVDC Circuit Breakers", IEEE TRANSACTIONS ON POWER APPARATUS AND SYSTEMS, IEEE INC. NEW YORK, US, vol. 82, no. 5, 1 September 1974 (1974-09-01), pages 1353-1358, XP011161445, ISSN: 0018-9510 * page 1, paragraph Aspects_of_the_design_of_HVDC_load_breakers - page 2, paragraph Diagrams_and_performances_of_test_circuits; figures 1,2,1A * * Point (7); page 5 - page 5 * ----- | 1-14 | **TECHNICAL FIELDS SEARCHED (IPC)** |

The present search report has been drawn up for all claims

| Place of search | Date of completion of the search | Examiner |
|---|---|---|
| Munich | 24 February 2014 | Maric, Viktor |

EPO FORM 1503 03.82 (P04C01)

**ANNEX TO THE EUROPEAN SEARCH REPORT
ON EUROPEAN PATENT APPLICATION NO.**

EP 13 18 4845

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2014

| Patent document cited in search report | | Publication date | Patent family member(s) | | Publication date |
|---|---|---|---|---|---|
| DE 3444317 | A1 | 15-05-1986 | CA | 1294327 C | 14-01-1992 |
| | | | CH | 665053 A5 | 15-04-1988 |
| | | | DE | 3444317 A1 | 15-05-1986 |
| | | | JP | S61121217 A | 09-06-1986 |
| | | | US | 4831487 A | 16-05-1989 |
| US 2011080684 | A1 | 07-04-2011 | NONE | | |
| US 5262605 | A | 16-11-1993 | AT | 112888 T | 15-10-1994 |
| | | | BR | 9005573 A | 17-09-1991 |
| | | | CA | 2028592 A1 | 04-05-1991 |
| | | | CN | 1051454 A | 15-05-1991 |
| | | | DE | 69013300 D1 | 17-11-1994 |
| | | | DE | 69013300 T2 | 16-02-1995 |
| | | | EP | 0431306 A1 | 12-06-1991 |
| | | | ES | 2063226 T3 | 01-01-1995 |
| | | | FR | 2654251 A1 | 10-05-1991 |
| | | | JP | H03179626 A | 05-08-1991 |
| | | | US | 5262605 A | 16-11-1993 |

EPO FORM P0459

For more details about this annex : see Official Journal of the European Patent Office, No. 12/82